# EUROPÄISCHE PATENTSCHRIFT

(11) **EP 1 298 708 B1**
(45) Veröffentlichungstag und Bekanntmachung des Hinweises auf die Patenterteilung: **06.02.2008**
(21) Anmeldenummer: 02018034.5
(22) Anmeldetag: 13.08.2002
(51) Int. Cl.: H01L 21/00, H01L 21/68

(54) **Ringförmige Aufnahme für einen rotierenden Träger**
Ring-shaped receptacle for a rotating support
Logement en forme d'anneau pour un support rotatif

(30) Priorität: 26.09.2001 AT 15182001
(43) Veröffentlichungstag der Anmeldung: 02.04.2003
(73) Patentinhaber: SEZ AG, 9500 Villach (AT)
(72) Erfinder: Obweger, Rainer, Ing., 9753 Lind im Drautal (AT)

(56) Entgegenhaltungen:
- EP-A- 0 444 714
- DE-A1- 19 807 460

## Beschreibung

Die Erfindung betrifft eine ringförmige Aufnahme, insbesondere für einen rotierenden Träger zur Aufnahme eines scheibenförmigen Gegenstandes wie eines Halbleiters. Soweit im Folgenden von Halbleitern oder Wafern gesprochen wird, umfasst dieser Begriff alle Arten scheibenförmiger Gegenstände wie CDs oder Magnetscheiben.

Zum Bearbeiten von scheibenförmigen Halbleitern, beispielsweise zum Ätzen von Siliziumscheiben (Wafern) mit gegebenenfalls verschiedenen Säuren ist es bekannt, die Halbleiter auf einem rotierenden Träger (sogenannter Chuck) anzuordnen. Auf die zu behandelnde Oberfläche des Halbleiters wird eine Behandlungsflüssigkeit, beispielsweise eine Säure, aufgetragen. Die Ätzflüssigkeit verteilt sich aufgrund der Rotationsbewegung des Halbleiters über dessen Oberfläche und wird seitlich (radial) über die Kante des Halbleiters weggeschleudert.

Zum Auffangen dieser Behandlungsflüssigkeit wird in der EP 0 444 714 B1 vorgeschlagen, in der ringförmigen Aufnahme (Topf) wenigstens zwei zu dessen Innenraum hin offene Ringkanäle zum Ansammeln der Behandlungsflüssigkeit vorzusehen. Mit anderen Worten: die Ringkanäle dienen dazu, abgeschleuderte Prozessflüssigkeit aufzufangen. Entsprechend sind die Ringkanäle in radialer Verlängerung des zu behandelnden Halbleiters in der Aufnahme angeordnet. In der DE 198 07 460 A1 wird eine gattungsgemäße ringförmige Aufnahme beschrieben, die neben dem ringförmigen Kanal, über den die Behandlungsflüssigkeit weggeführt wird, mindestens eine Absaugeinrichtung aufweist. Grundgedanke dieser bekannten Lösung ist es, unabhängig von der radialen Aufnahme abgeschleuderter Prozessflüssigkeit die im System (der Anlage) befindliche Prozessluft (Prozessgas) getrennt abzusaugen.

Aufgrund der im Wesentlichen rotationssymmetrischen Konstruktion der Aufnahme ergibt sich jedoch das Problem einer ungleichmäßigen Absaugleistung, wenn, wie in der DE 198 07 460 A1 vorgeschlagen, die Absaugung der in dem Ringkanal gesammelten Prozessluft über eine radial verlaufende Anschlussleitung erfolgt. Darüber hinaus ist die bekannte Aufnahme relativ groß. Daraus ergeben sich Platzprobleme in Reinräumen, wo derartige Vorrichtungen aufgestellt werden. Der für eine Vorrichtung benötigte Platzbedarf ist eine nicht unerhebliche Einflussgröße für die gesamten Produktionskosten.

Schließlich erfordert die bekannte Vorrichtung aufgrund unterschiedlicher Druckverhältnisse (über den Umfang der Vorrichtung betrachtet) eine relativ hohe Absaugleistung, die zum Beispiel für Wafer mit einem Durchmesser von 30 cm bis 1.000 m3/h betragen kann.

Der Erfindung liegt insoweit die Aufgabe zugrunde, eine Vorrichtung (Aufnahme) der genannten Art konstruktiv zu optimieren, um mindestens einen, vorzugsweise alle nachfolgenden Kriterien zu erfüllen:
- Die Vorrichtung soll bei einer definierten Größe der zu behandelnden Gegenstände möglichst klein sein,
- es werden möglichst gleichmäßige Druckbedingungen (in Umfangsrichtung der Vorrichtung betrachtet) bezüglich der jeweiligen Absaugeinrichtung angestrebt,
- die benötigte Saugleistung soll aus Kostengründen so gering wie möglich sein,
- es wird eine möglichst präzise Trennung unterschiedlicher Behandlungsmedien, einschließlich der jeweiligen Prozessatmosphäre, angestrebt.

Zur Lösung dieser und weiterer Aufgabenteile, die sich aus den übrigen Anmeldungsunterlagen ergeben, geht die Erfindung von folgender Grundüberlegung aus: Bei einem im Wesentlichen rotationssymmetrischen Bauteil, wie einer gattungsgemäßen Aufnahme, lassen sich bei einer mehr oder weniger punktuell wirkenden Unterdruckquelle dann keine gleichmäßigen Druckverhältnisse in der Aufnahme einstellen, sofern die einzelnen Zuführleitungen unmittelbar in einen gemeinsamen Umfangskanal einmünden, von dem die Absaugleitung wegführt.

Die Druckverhältnisse werden demgegenüber nachhaltig verbessert, wenn die wegzuführende Atmosphäre zunächst in einen Absaugraum geführt wird und von dort in eine Druckverteilkammer, an die eine Saugleitung angeschlossen ist.

Die damit verbundenen Vorteile werden besonders deutlich bei "mehretagigen Aufnahmen", also Vorrichtungen, bei denen der Träger für den zu behandelnden Gegenstand vertikal verschiebbar ist und in verschiedenen vertikalen Höhen verschiedene Behandlungsprozesse ausgeführt werden. So kann zum Beispiel in einer Stufe ein Wafer geätzt werden, in einer anderen Stufe wird die Waferoberfläche mit deionisiertem Wasser gespült. In diesem Fall sind jeder Behandlungsstufe korrespondierende ringförmige Kanäle zugeordnet, über die die jeweilige Prozessflüssigkeit abgeführt wird. Jedem ringförmigen Kanal ist dann wiederum eine Absaugeinrichtung zugeordnet, die auf die vorstehend und nachstehend beschriebene Art und Weise ausgebildet ist. Mehrere Absaugeinrichtungen münden vorzugsweise in ein und dieselbe Druckverteilkammer, die eine Vergleichmäßigung der Absaugleistung bewirkt, wobei der entsprechende Unterdruck, wie im Stand der Technik, über eine zentrale Saugleitung erfolgen kann.

Danach betrifft die Erfindung in ihrer allgemeinsten Ausführungsform eine ringförmige Aufnahme für einen rotierenden Träger zur Aufnahme eines scheibenförmigen Gegenstandes mit folgenden Merkmalen:
- Die Aufnahme weist mindestens einen ringförmigen Kanal in radialer Verlängerung einer Auflagefläche des Trägers für den Gegenstand auf,
- benachbart mindestens eines ringförmigen Kanals verläuft in der Aufnahme, ausgehend von deren Innenwand, mindestens eine Absaugeinrichtung,
- die Absaugeinrichtung umfasst im Bereich der Innenwand angeordnete Absaugöffnungen und einen an das saugseitige Ende der Absaugöffnungen radial anschließenden ringförmigen Absaugraum,
- mindestens eine Druckverteilkammer verbindet eine Saugleitung mit dem Absaugraum.

Ebenso wie die zu behandelnden Gegenstände, zum Beispiel Wafer, wird auch die Vorrichtung im Wesentlichen rotationssymmetrisch sein. "Im Wesentlichen rotationssymmetrisch" bedeutet dabei, dass (mit Ausnahme der zentralen Saugleitung) die weiteren Vorrichtungsteile im Wesentlichen gleichmäßig verteilt um eine Mittenlängsachse der Vorrichtung angeordnet sind.

Korrespondierend zu den ringförmigen Kanälen, über die abgeschleuderte Prozessflüssigkeit weggeführt werden kann, sind beispielsweise auch die Absaugöffnungen entlang einer Ringfläche angeordnet, die unmittelbar Bestandteil der Innenwand der Aufnahme sein kann. Die Absaugöffnungen können oberhalb und/oder unterhalb des zugehörigen ringförmigen Kanals oder der zugehörigen ringförmigen Kanäle verlaufen, wie anhand der nachstehenden Figurenbeschreibung noch erläutert wird. Die Absaugöffnungen können einfache Löcher (Bohrungen) sein, aber auch nach Art von Absaugdüsen gestaltet werden. Ebenso können Absaugschlitze vorgesehen werden.

Der den Absaugöffnungen in Strömungsrichtung nachgeschaltete Absaugraum kann sich in einer horizontalen Ebene unmittelbar radial außenseitig an die Absaugöffnungen anschließen. Nach einer Ausführungsform verläuft mindestens ein Absaugraum allerdings, ausgehend von der Innenwand der Aufnahme, abfallend nach außen beziehungsweise in Bezug auf die Auflagefläche eines zugehörigen Trägers.

Vom Absaugraum gelangt das abgesaugte Gas über eine "Schikane" (im Querschnitt verjüngte Stelle) in die angeschlossene Druckverteilkammer.

Der Absaugraum kann über diskrete Öffnungen mit der Druckverteilkammer verbunden werden. Mit anderen Worten:
Ebenso wie die Absaugöffnungen zwischen dem Innenraum der Aufnahme und dem Absaugraum können auch die Verbindungen zwischen dem Absaugraum und der in Strömungsrichtung anschließenden Druckverteilkammer im Wesentlichen beliebig gestaltet sein.

Um eine Vergleichmäßigung der Druckverhältnisse zu optimieren, bietet sich jedoch auch bezüglich der Öffnungen zwischen Absaugraum und Druckverteilkammer eine rotationssymmetrische Anordnung an.

Bei einer Aufnahme mit mehreren, übereinander in der Aufnahme verlaufenden, ringförmigen Kanälen und diesen zugeordneten Absaugeinrichtungen sieht eine Ausführungsform vor, dass mindestens zwei Absaugeinrichtungen, gegebenenfalls auch alle Absaugeinrichtungen, mit derselben Druckverteilkammer verbunden sind. Auf diese Weise werden in einzelnen "Etagen" der Vorrichtung die betreffenden Prozessgase zwar getrennt in unterschiedliche Absaugräume abgesaugt, anschließend von dort aber einer gemeinsamen Druckverteilkammer zugeführt, so dass sich insgesamt im Wesentlichen isotrope Druckverhältnisse über die gesamte Anlage einstellen.

Dabei bietet es sich an, wie in der Figurenbeschreibung noch erläutert wird, die Druckverteilkammer als umlaufende Kammer mit relativ geringer Breite auszubilden, die sich jedoch im Wesentlichen über die gesamte Höhe der Aufnahme erstreckt.

An die einzelnen Kanäle, über die Prozessflüssigkeit weggeführt wird, können Ablaufleitungen angeschlossen werden. Wahlweise kann dies so erfolgen, dass die Prozessflüssigkeit anschließend wieder rezirkuliert wird, also beispielsweise zu einer Bedüsungseinrichtung oberhalb des scheibenförmigen Gegenstandes zurückgeführt wird.

Dabei können mehrere, ringförmige Kanäle an eine gemeinsame Ablaufleitung angeschlossen werden, insbesondere dann, wenn gleiche oder kompatible Flüssigkeiten über die entsprechenden Kanäle weggeführt werden.

Die beschriebene Bauform ermöglicht es, die Absaugleistung gegenüber vergleichbaren Vorrichtungen nach dem Stand der Technik um bis zu 75 % zu reduzieren. Dies ist insbesondere eine Folge der Vergleichmäßigung der Druckverhältnisse und der Optimierung der Luftführung. Darüber hinaus lässt sich die Aufnahme kompakt gestalten und benötigt sehr wenig Platz. Beispielsweise zur Behandlung von Wafern mit einem Durchmesser von 30 cm kann der Außendurchmesser der Vorrichtung auf rund 60 cm und weniger beschränkt werden.

Weitere Merkmale der Erfindung ergeben sich aus den Merkmalen der Unteransprüche sowie den sonstigen Anmeldungsunterlagen.

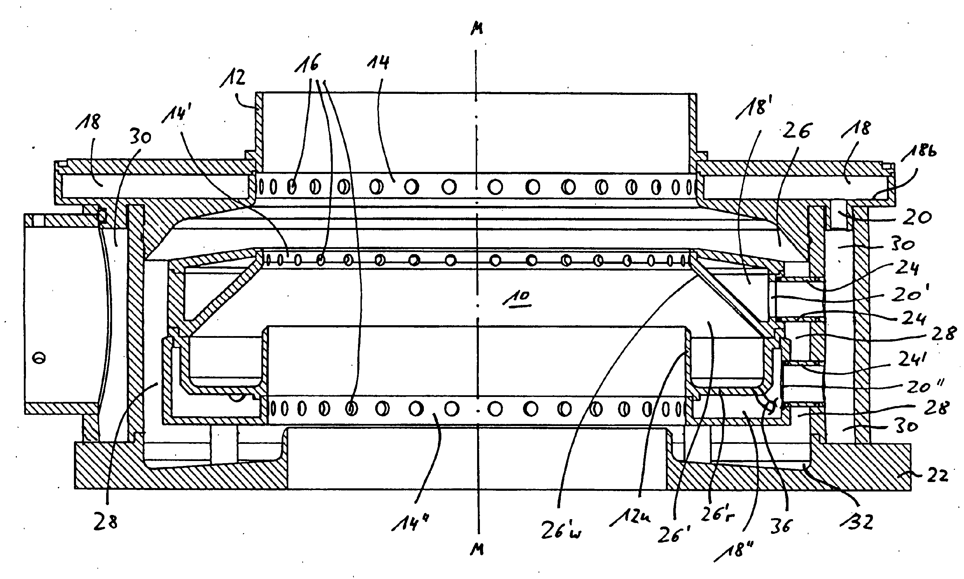

Die Erfindung wird nachstehend anhand eines Ausführungsbeispieles näher erläutert. Die einzige Figur zeigt einen Längsschnitt durch eine ringförmige (topfförmige) mehrstufige Aufnahme, und zwar ohne Träger für den zu behandelnden Gegenstand, weil dieser Stand der Technik ist und beispielsweise der DE 198 07 460 A1 entnommen werden kann.

Die Aufnahme besitzt einen zylinderförmigen Innenraum 10, der von einer Innenwand 12 der Aufnahme begrenzt wird. In dem Innenraum 10 ist ein (nicht dargestellter) Träger vertikal verstellbar angeordnet. Auf dem Träger liegt der zu behandelnde Gegenstand flach auf.

Im Bereich der Innenwand 12 befindet sich eine erste Ringzone 14 mit Absaugöffnungen 16, an die sich umfangsseitig (radial) ein korrespondierender Absaugraum 18 anschließt. Im Boden 18b des Absaugraums 18 sind rotationssymmetrisch verteilt Öffnungen 20 angeordnet, die in eine Druckverteilkammer münden, die konzentrisch zur Mittenlängsachse M der Vorrichtung verläuft und eine Höhe (parallel zur Mittenlängsachse M) aufweist, die ein Vielfaches größer ist als die Kammerbreite (Kanalbreite). Die Druckverteilkammer 30 wird am unteren Ende von einer Bodenplatte 22 begrenzt.

Beabstandet unterhalb der (oberen) Ringzone 14 ist eine weitere Ringzone 14' vorgesehen, die analog der Ringzone 14 aufgebaut ist. An diese Ringzone 14' schließt sich außenseitig ein Ringraum 18' an. Während der Ringraum 18 in einer horizontalen Ebene an die Ringzone 14 anschließt, fällt der Absaugraum 18', ausgehend von der Ringzone 14', nach unten und nach außen ab. Insgesamt ergibt sich dabei ein in etwa dreieckförmiges Querschnittsprofil mit einer im Wesentlichen vertikalen äußeren Wand, in der, umfangsseitig verteilt, Öffnungen 20' angeordnet sind, an die sich rohrförmige Distanzstücke 24 radial nach außen anschließen, um eine Durchgangsverbindung vom Absaugraum 18' zur Druckverteilkammer 30 zu schaffen.

Zwischen den Ringzonen 14, 14' wird gleichzeitig ein ringförmiger Kanal 26 begrenzt, der sich radial nach außen an den zylinderförmigen Innenraum 10 anschließt und im Wesentlichen zwischen den Absaugräumen 18, 18' verläuft.

Der ringförmige Kanal 26 geht außenseitig in einen parallel zur Druckverteilkammer 30 verlaufenden Kanal 28 über, der in einer Art Bodenrinne 32 mündet, von der eine Schlauchleitung 34 wegführt.

Wie sich der Figur entnehmen lässt, verlaufen die Distanzstücke 24 quer durch den Kanal 28, ohne jedoch die vertikale Durchströmbarkeit des Kanals 28 zu beeinträchtigen.

Unterhalb der Ringzone 14' verläuft mit Abstand eine weitere Ringzone 14", die im Wesentlichen wieder analog den Ringzonen 14, 14' gestaltet ist. Ähnlich wie bei der Ringzone 14 schließt sich außenseitig ein Absaugraum 18" an, dessen umfangsseitige Wandfläche Öffnungen 20" besitzt, an die sich (wie an die Öffnungen 20') Distanzstücke 24' anschließen, die eine strömungstechnische Verbindung zwischen dem Absaugraum 18" und der Druckverteilkammer 30 schaffen.

Zwischen den Ringzonen 14', 14" ist ein weiterer Kanal 26' ausgebildet, der neben einer schräg verlaufenden oberen Wand 26'w einen unteren rinnenartigen, umlaufenden Teil 26'r umfasst, von dem eine Stichleitung 36 wegführt.

Der Abschnitt 26'r ist innenseitig von einem Teilstück 12u der Innenwand 12 begrenzt.

### Die Funktion der Vorrichtung ist beispielsweise wie folgt:

Ein Träger mit einem Wafer wird auf eine Position zwischen die Ringzonen 14', 14" geführt und rotierend angetrieben. Der Wafer wird von oben mit einer Ätzflüssigkeit behandelt, die radial nach außen in den Kanal 26' abgeschleudert und über die Stichleitung 36 weggeführt wird. Gleichzeitig erfolgt über die Ringzone 14' eine Absaugung der Prozessluft über den Absaugraum 18' und die Distanzstücke 24 in die Druckverteilkammer 30, die, wie im linken Teil der Figur dargestellt, an eine zentrale Saugleitung 38 angeschlossen ist.

Gleichzeitig kann über die weiteren Ringzonen 14, 14" ebenfalls abgesaugt werden, wobei die gesamte Prozessluft (wenngleich auf unterschiedlichen Wegen) im Ergebnis in der Druckverteilkammer 30 mündet und von dort über die Saugleitung 38 abgezogen wird.

Nach diesem Prozessschritt kann der Träger angehoben und in eine Position zwischen die Ringzonen 14, 14' gebracht werden. Er kann hier beispielsweise mit deionisiertem Wasser behandelt werden, welches umfangsseitig in den Kanal 26 geschleudert wird, wo es über den Kanal 28 in die Bodenrinne 32 läuft und dort über die Schlauchleitung 34 abgezogen wird.

Durch die im Wesentlichen parallele Anordnung der Druckverteilkammer 30 (Abführleitung für gasförmige Medien) und des Kanals 28 (zur Wegführung einer Prozessflüssigkeit) lässt sich eine weitere Reduzierung der Größe der Vorrichtung erreichen.

## Patentansprüche

1. Ringförmige Aufnahme für einen rotierenden Träger zur Aufnahme eines scheibenförmigen Gegenstandes mit folgenden Merkmalen:
1.1 die Aufnahme weist mindestens einen ringförmigen Kanal (26, 26') in radialer Verlängerung einer Auflagenfläche des Trägers für den Gegenstand auf,
1.2 benachbart mindestens eines ringförmigen Kanals (26, 26') verläuft in der Aufnahme, ausgehend von deren Innenwand (12), mindestens eine Absaugeinrichtung,
1.3 die Absaugeinrichtung umfasst
1.3.1 im Bereich der Innenwand (12) angeordnete Absaugöffnungen (16),
1.3.2 einen an das saugseitige Ende der Absaugöffnungen (16) radial anschließenden ringförmigen Absaugraum (18, 18', 18"), .
1.4 eine Druckverteilkammer (30) verbindet eine Saugleitung (38) mit dem Absaugraum (18, 18', 18").

2. Aufnahme nach Anspruch 1, bei der die Absaugöffnungen (16) oberhalb des ringförmigen Kanals (26, 26') verlaufen.

3. Aufnahme nach Anspruch 1, bei der die Absaugöffnungen (16) aus einer Vielzahl, weitestgehend gleichmäßig entlang der Innenwand (12) der Aufnahme verteilten Absaugdüsen bestehen.

4. Aufnahme nach Anspruch 1, bei der die Absaugöffnungen (16) auf einer Ringfläche (14, 14', 14") angeordnet sind.

5. Aufnahme nach Anspruch 1, bei der der Absaugraum (18, 18', 18") über diskrete Öffnungen (20, 20', 20") mit der Druckverteilkammer (30) verbunden sind.

6. Aufnahme nach Anspruch 1 mit mehreren, übereinander in der Aufnahme verlaufenden ringförmigen Kanälen (26, 26') und diesen zugeordneten Absaugeinrichtungen, wobei mindestens zwei Absaugeinrichtungen mit derselben Druckverteilkammer (30) verbunden sind.

7. Aufnahme nach Anspruch 1, bei der der Absaugraum (18') mindestens einer Absaugeinrichtung, ausgehend von der Innenwand (12) der Aufnahme, in Bezug auf die Auflagefläche des Trägers abfallend verläuft.

8. Aufnahme nach Anspruch 1 mit einer, an einen ringförmigen Kanal (26, 26') angeschlossenen Ablaufleitung (34, 36), die wahlweise zu einer Bedüsungseinrichtung oberhalb des scheibenförmigen Gegenstandes zurückgeführt ist.

9. Aufnahme nach Anspruch 8, bei der mehrere ringförmige Kanäle (26, 26') an eine gemeinsame Ablaufleitung angeschlossen sind.

10. Aufnahme nach Anspruch 1, bei der die Druckverteilkammer (30) eine relativ geringe Breite aufweist, sich jedoch im Wesentlichen über die gesamte Höhe der Aufnahme erstreckt.

## Claims

1. Annular receiving means for a rotating support for receiving a disc-shaped object, having the following features:
1.1 the receiving means has at least one annular channel (26, 26') in the radial extension of a support face of the support for the object,
1.2 adjacent at least to one annular channel (26, 26') there extends in the receiving means, starting from the inner wall (12) thereof, at least one suction device,
1.3 the suction device comprises
1.3.1 suction openings (16) disposed in the region of the inner wall (12),
1.3.2 an annular suction chamber (18, 18', 18") which connects radially to the suction-side end of the suction openings (16),
1.4 a pressure distribution chamber (30) connects to the suction chamber (18, 18', 18'').

2. Receiving means according to claim 1, in which, the suction openings (16) extend above the annular channel (26, 26').

3. Receiving means according to claim 1, in which the suction openings (16) comprise a multiplicity of suction nozzles which are distributed as far as possible, uniformly the inner wall (12) of the receiving means.

4. Receiving means according to claim 1, in which the suction openings (16) are disposed on an annular face (14, 14', 14").

5. Receiving means according to claim 1, in which the suction chamber (18, 18', 18") is connected to the pressure distribution chamber (30) via discrete openings (20, 20', 20").

6. Receiving means according to claim 1, having a plurality of annular channels (26, 26') which extend one above the other in the receiving means and suction devices associated with the latter, at least two suction devices being connected to the same pressure distribution chamber (30).

7. Receiving means according to claim 1, in which the suction chamber (18') of at least one suction device extends, starting from the inner wall (12) of the receiving means, inclined downwards relative to the support face of the support.

8. Receiving means according to claim 1, having a discharge line (34, 36) which is connected to an annular channel (26, 26') and is optionally guided back to a nozzle treatment device above the disc-shaped object.

9. Receiving means according to claim 8, in which a plurality of annular channels (26, 26') is connected to a common discharge line.

10. Receiving means according to claim 1, in which the pressure distribution chamber (30) has a relatively narrow width, but extends substantially over the entire height of the receiving means.

## Revendications

1. Elément de réception annulaire pour un support rotatif destiné à recevoir un objet en forme de disque, présentant les caractéristiques suivantes :
1.1 l'élément de réception comporte au moins un canal (26, 26') annulaire dans le prolongement radial d'une surface d'appui du support pour l'objet,
1.2 à proximité d'au moins un canal (26, 26') annulaire, au moins un dispositif d'aspiration s'étend dans l'élément de réception, en partant de la paroi intérieure (12) de celui-ci,
1.3 le dispositif d'aspiration comprend
1.3.1 des orifices d'aspiration (16) disposés dans la région de la paroi intérieure (12),
1.3.2 une chambre d'aspiration (18, 18', 18") annulaire qui se raccorde dans la direction radiale à l'extrémité côté aspiration des orifices d'aspiration (16),
1.4 une chambre de répartition de pression (30) relie une conduite d'aspiration (38) à la chambre d'aspiration (18, 18', 18").

2. Elément de réception selon la revendication 1, dans lequel les orifices d'aspiration (16) se situent au-dessus du canal (26, 26') annulaire.

3. Elément de réception selon la revendication 1, dans lequel les orifices d'aspiration (16) sont constitués d'une pluralité de buses d'aspiration qui sont réparties de façon sensiblement régulière le long de la paroi intérieure (12) de l'élément de réception.

4. Elément de réception selon la revendication 1, dans lequel les orifices d'aspiration (16) sont disposés sur une surface annulaire (14, 14', 14").

5. Elément de réception selon la revendication 1, dans lequel la chambre d'aspiration (18, 18', 18") communique avec la chambre de répartition de pression (30) par des orifices (20, 20', 20") discrets.

6. Elément de réception selon la revendication 1, comprenant plusieurs canaux (26, 26') annulaires, disposés les uns au-dessus des autres dans l'élément de réception, et des dispositifs d'aspiration associés auxdits canaux, sachant qu'au moins deux dispositifs d'aspiration sont reliés à la même chambre de répartition de pression (30).

7. Elément de réception selon la revendication 1, dans lequel la chambre d'aspiration (18') d'au moins un dispositif d'aspiration s'étend vers le bas par rapport à la surface d'appui du support, en partant de la paroi intérieure (12).

8. Elément de réception selon la revendication 1, comprenant une conduite d'évacuation (34, 36) qui est raccordée à un canal (26, 26') annulaire et revient de manière facultative à un dispositif d'injection par buses installé au-dessus de l'objet en forme de disque.

9. Elément de réception selon la revendication 8, dans lequel plusieurs canaux (26, 26') annulaires sont raccordés à une conduite d'évacuation commune.

10. Elément de réception selon la revendication 1, dans lequel la chambre de répartition de pression (30) présente une largeur relativement faible, mais s'étend sensiblement sur toute la hauteur de l'élément de réception.
